(19) **Europäisches Patentamt**

**European Patent Office**

**Office européen des brevets**

(11) **EP 1 413 648 B1**

(12) **EUROPEAN PATENT SPECIFICATION**

(45) Date of publication and mention
of the grant of the patent:
**29.06.2005 Bulletin 2005/26**

(51) Int Cl.[7]: **C23C 30/00**, C23C 16/30

(21) Application number: **03256054.2**

(22) Date of filing: **26.09.2003**

(54) **Coated cutting tool**

Beschichtetes Schneidwerkzeug

Outil de coupe revêtu

(84) Designated Contracting States:
**DE SE**

(30) Priority: **27.09.2002 JP 2002284413**

(43) Date of publication of application:
**28.04.2004 Bulletin 2004/18**

(73) Proprietor: **SUMITOMO ELECTRIC INDUSTRIES, Ltd**
**Osaka-shi, Osaka 541-0041 (JP)**

(72) Inventors:
 • **Okada, Yoshio**
 **1-1, Koyakita 1-chome, Itami-shi, Hyogo (JP)**
 • **Itoh, Minoru**
 **1-1, Koyakita 1-chome, Itami-shi, Hyogo (JP)**
 • **Moriguchi, Hideki**
 **1-1, Koyakita 1-chome, Itami-shi, Hyogo (JP)**

(74) Representative:
**Cross, Rupert Edward Blount et al**
**BOULT WADE TENNANT,**
**Verulam Gardens**
**70 Gray's Inn Road**
**London WC1X 8BT (GB)**

(56) References cited:
 US-A- 5 912 051        US-A- 5 945 207
 US-A- 6 093 479

 • PATENT ABSTRACTS OF JAPAN vol. 2000, no. 20, 10 July 2001 (2001-07-10) & JP 2001 071203 A (MITSUBISHI MATERIALS CORP), 21 March 2001 (2001-03-21)
 • PATENT ABSTRACTS OF JAPAN vol. 007, no. 213 (C-187), 20 September 1983 (1983-09-20) & JP 58 110654 A (MITSUBISHI KINZOKU KK), 1 July 1983 (1983-07-01)

EP 1 413 648 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to a coated cutting tool having a coating over its substrate, particularly a coated cutting tool capable of having an increased tool life because of its excellent wear resistance even under the working condition that the cutting part is subjected to high temperatures resulting from high-speed, high-efficiency machining.

Continuous cutting and interrupted cutting of various materials such as steel and cast iron have been performed with a coated cemented-carbide cutting tool or a coated cermet-alloy cutting tool, which has a coating having an average thickness of 3 to 20 μm formed over its substrate made of cemented carbide or cermet alloy by using the chemical vapor deposition (CVD) method or the physical vapor deposition (PVD) method. Usually, the cemented carbide is based on tungsten carbide (hereinafter referred to as WC), and the cermet alloy is based on titanium carbonitride (hereinafter referred to as TiCN). Usually, the coating is composed of an inner layer made of at least one titanium compound selected from titanium carbide (hereinafter referred to as TiC), titanium nitride (hereinafter referred to as TiN), TiCN, titanium oxycarbide (hereinafter referred to as TiCO), and titanium oxycarbonitride (hereinafter referred to as TiCNO) and an outer layer made of aluminum oxide (hereinafter referred to as $Al_2O_3$).

Patent document 1 shown below has proposed that the TiCN layer be produced by using organic carbonitride as the reaction gas in an ordinary CVD apparatus at moderate temperature so that the TiCN layer can have a columnar structure in order to improve the wear resistance.

Patent document 2 shown below has proposed that the TiCNO layer be produced by using $TiCl_4$, $CH_3CN$, CO, $N_2$, and $H_2$ gases so that the TiCNO layer can have the highest peak intensity at the (111) plane in the X-ray diffraction analysis and have atomic ratios shown in $TiC_uN_vO_w$ satisfying $u \geq v > w > 0$ and $u + v + w = 1$ and $0.05 \geq w > 0$ in order to improve the performance in interrupted cutting.

Patent document 3 shown below has proposed that the TiCNO layer be produced such that the TiCNO layer has the highest peak intensity at the (422) or (311) plane in the X-ray diffraction analysis and has an oxygen content of 0.05 to 3 wt. %.

Patent document 4 shown below has proposed that the TiCNO layer be produced such that the TiCNO layer has atomic ratios shown in $TiC_xO_yN_z$ satisfying $0.7 \leq x + y + z \leq 1.3$ and $0.4 < y < 0.6$.

Patent document 5 shown below has proposed that the TiCNO layer be produced such that the TiCNO layer contains oxygen diffused from a layer immediately underneath made of $TiO_v$, where v is an atomic ratio of "O" to "Ti" and lies in the range of 1.2 to 1.7, and has atomic ratios shown in $TiC_xN_y(O_z)$ satisfying $x + y + z = 1$ and $0.25 \leq x \leq 0.65$ and $0.25 \leq y \leq 0.65$ and $0.01 \leq z \leq 0.4$.

(Patent document 1): published Japanese patent 2974284
(Patent document 2): published Japanese patent application *Tokukaihei 8*-257808
(Patent document 3): published Japanese patent application *Tokukai* 2000-158209
(Patent document 4): published Japanese patent application *Tokukaihei* 8-47999
(Patent document 5): published Japanese patent application *Tokukai* 2001-71203

Further relevant documents are D6 (JP(A) 58110654), D7 (US-A-5912051) and D8 (US-A-5945207).

D6 provides for a coating of cutting tools made from a cermet substrate. The coating may comprise an inner layer of a carbide or a nitride and an outer layer of an oxycarbonitride. Tables 1, 3 and 4 show examples of $TiC_xN_yO_z$ layers having atomic ratios laying within the ranges specified by (c) of claim 1. However, D6 does not teach that the $TiC_xN_yO_z$ layer constitutes at least one half of the average total thickness of the coating.

D7 and D8 both teach coatings for cutting inserts of a hard-alloy, the coatings being comprised of several layers:

- an innermost layer of $TiC_xN_yO_z$ having equiaxed grains
- next layer of $TiC_xN_yO_z$ having columnar grains
- a further layer of $TiC_xN_yO_z$ having equiaxed grains
- an outermost layer of $Al_2O_3$ and
- optionally a final layer of TiN.

The atomic ratios disclosed in D7 and D8 for the $TiC_xN_yO_z$ layer with the columnar structure are different from the layer of claim 1 of the present invention. In addition, it is preferred that the $TiC_xN_yO_z$ layer of D7 and D8 does not even contain oxygen at all (z=0).

The cutting operation has a tendency to increase the speed because of the improvement of the performance and increase in output of cutting machines in addition to the consideration of labor and energy saving in cutting operation in recent years. Furthermore, the environment protection issues have promoted dry machining, which does not use cutting fluid. As a result, the cutting part of the cutting tool is subjected to a temperature as high as about 1,000 °C at the time of machining. The above-described coated cutting tools are intended to improve the mechanical strength, bonding strength, and lubricity at the time of interrupted cutting particularly by coating the tool with the TiCNO layer. However, the above-described shift in the machining method makes it difficult to suppress the wear of the tool in the conventional coated cutting tools. As a result, the tool reaches the end of its useful life in comparatively short time.

More specifically, in the technique proposed by Patent document 2, the TiCNO layer contains an extremely small amount of oxygen as shown by $0.05 \geq w > 0$. Consequently, the TiCNO layer cannot work with excellent cutting performance supported by sufficient wear and breakage resistance under the working condition that the cutting part is subjected to high temperatures resulting from high-speed, high-efficiency machining.

In the technique proposed by Patent document 3, the TiCNO layer contains an extremely small amount of oxygen. When the atomic ratio of the oxygen to the oxycarbonitride is calculated by using the weight percentage of the oxygen, the atomic ratio lies in the range of 0.001 to 0.06. This amount is comparable to that specified in Patent document 2. (Patent document 3 does not clearly state the contents (atomic ratios) of carbon and nitrogen.) As a result, the TiCNO layer reaches the end of its useful life in comparatively short time in high-speed, high-efficiency machining as in Patent document 2.

In the technique proposed by Patent document 4, the TiCNO layer is intended to function as a bonding layer between the layer directly beneath (the first layer) and the layer directly above (the third layer) and to function as a layer for preventing the diffusion of cobalt from the substrate to the coating. Consequently, the TiCNO layer is thinner than the third layer. The thin and oxygen-rich TiCNO layer cannot be expected to have improved wear resistance, in particular, in the present-day technology.

In the technique proposed by Patent document 5, the TiCNO layer has a thickness of 0.05 to 2 μm, which is relatively thin. In addition, the layer is formed by using diffused oxygen to attain lubricity. As a result, it is difficult to improve the wear resistance.

The principal object of the present invention is to offer a coated cutting tool having long tool life because of its excellent wear resistance even under the working condition that the cutting part is subjected to high temperatures resulting from high-speed, high-efficiency machining.

The present invention achieves the foregoing object by specifying the following properties of the TiCNO layer: the atomic ratios of carbon, nitrogen, and oxygen; the thickness; the constituting percentage in the entire coating; the crystal structure; and the highest peak intensity in the X-ray diffraction analysis.

According to the present invention, the coated cutting tool has a coating formed over its hard-alloy substrate. The coating comprises a first compound layer that comprises at least one layer and that has an average layer thickness of at least 0.5 μm and at most 20 μm. The thickness constitutes at least one-half the average total thickness of the coating. The at least one layer is made of oxycarbonitride of a metal belonging to the IVa, Va, or VIa group in the periodic table. The at least one layer has:

(a) atomic ratios of carbon, nitrogen, and oxygen, expressed as $x$, $y$, and $z$, respectively, that satisfy the following formulae:

$$x > y > z \text{ and } x + y + z = 1$$

$$0.74 > x > 0.35, 0.45 > y > 0.20, \text{ and } 0.30 > z > 0.06;$$

(b) a columnar structure; and
(c) in the crystal structure, the largest orientational texture coefficient that lies in one of the orientational texture coefficients TC(220), TC(311), and TC(422) at the (220), (311), and (422) planes, respectively.

The present inventors intensively studied to develop a coated cutting tool having excellent cutting performance and an increased tool life even when it is used for high-speed, high-efficiency continuous or interrupted cutting with the consideration of environment protection. The study was focused particularly on the wear resistance of the coating. Then, the present inventors obtained the following findings. When a layer made of oxycarbonitride of a metal belonging to the IVa, Va, or VIa group in the periodic table, including the well-known TiCNO, is produced by specifying the following conditions as described above, the wear resistance can be improved over the conventional TiCNO layer even under the cutting condition that the cutting part is subjected to higher temperatures; Important features are:

(1) the atomic ratios of carbon ($x$), nitrogen ($y$), and oxygen ($z$);
(2) the items (b) and (c) above; and
(3) the average layer thickness.

As a result, the tool life can be further increased. The specification of the present invention is based on the above-described findings. The present invention is explained in further detail below.

In the present invention, the atomic ratios of carbon ($x$), nitrogen ($y$), and oxygen ($z$) in the first compound layer are specified as $x > y > z$ and $x + y + z = 1$. If the ratios do not satisfy the specification, the atomic structure in the layer tends to distort, making it difficult to improve the wear resistance in the intended high-speed, high-efficiency machining.

The atomic ratios are also required to satisfy the limitations of $0.74 > x > 0.35$, $0.45 > y > 0.20$, and $0.30 > z > 0.06$. If the atomic ratio of carbon is not less than 0.74 or the atomic ratio of nitrogen is not more than 0.20, the hardness of the layer increases. The hardness increase decreases the toughness, thereby increasing the possibility of the occurrence of fracture. As a result, the tool life is decreased. On the other hand, if the atomic ratio of carbon is not more than 0.35 or the atomic ratio of nitrogen is not less than 0.45, the layer wears away at a notably high rate, decreasing the tool life. If the atomic ratio of oxygen is not less than 0.30, the atomic structure distorts significantly, so that the layer tends to be brittle. On the other hand, if the atomic ratio of oxygen is not more than 0.06, the intended wear resistance cannot be achieved under the working condition that the cutting part is subjected to high temperatures. In particular, when the atomic ratios satisfy the limitations of $0.62 > x > 0.40$, $0.40 > y > 0.25$, and $0.20 > z > 0.13$, the wear resistance can be further improved.

In order to attain the atomic ratios of carbon ($x$), nitrogen ($y$), and oxygen ($z$) within the foregoing specified limits and to prevent the atomic structure from distorting, it is recommendable to produce the first compound layer by the following process. First, the following gases are used as the material gas: vaporized liquid organic carbonitride such as $CH_3CN$, chloride of a metal belonging to the IVa, Va, or VIa group in the periodic table such as $VCl_4$, $ZrCl_4$, and $TiCl_4$, hydrogen, and nitrogen. Other gases such as Ar, CO, and $CO_2$ may also be used as required. Next, $H_2O$ is added to the material gas such that the volume ratio of the $H_2O$ to the liquid organic carbonitride becomes at least 0.01 and at most 5.00. As described above, $H_2O$ may be added to the organic carbonitride to use the organic carbonitride as the source of $H_2O$. $H_2O$ may also be added to one of the other gases listed above to use the gas as the source of $H_2O$. Even when $H_2O$ is added to another gas, the volume ratio of $H_2O$ to the organic carbonitride is controlled to become at least 0.01 and at most 5.00. In addition to the volume control of $H_2O$, the temperature of the reaction atmosphere is controlled to be at least 700 °C and at most 1,000 °C, and the pressure of the reaction atmosphere is controlled to be at least 5 kPa and at most 20 kPa. When the volume ratio of $H_2O$ and the temperature and pressure of the reaction atmosphere are controlled to fall within the specified limits, the atomic ratios of carbon, nitrogen, and oxygen in the first compound layer can fall within the foregoing specified limits. It is recommendable to form the first compound layer by using the conventional CVD or PVD apparatus.

The atomic ratios may be measured with a well-known method such as the X-ray photoelectron spectroscopy, secondary ion mass spectrometry, or Auger electron spectroscopy. In the present invention, nonmetallic elements, such as chlorine, not more than 0.5 atomic % are treated as impurities in the measurement.

As described above, the present inventors found that when a proper amount of oxygen is added to the first compound layer by the above-described method, the wear resistance can be improved over the conventional coated cutting tool even under harsher cutting conditions and environments. Accordingly, the present invention first specifies the atomic ratios in the first compound layer as described above. The present inventors also found that the wear resistance can be further improved when the first compound layer made of the foregoing oxycarbonitride satisfies the following conditions:

(a) The layer has an average layer thickness of at least 0.5 μm and at most 20 μm.
(b) The thickness constitutes at least one-half the average total thickness of the coating (constituting ratio: at least 0.5).
(c) The layer has a columnar structure.

Accordingly, the present invention specifies the layer thickness, constituting ratio, and crystal structure as described above.

In the present invention, when the first compound layer comprises two or more layers, whether the layers have the same atomic ratios or different ones, the term "average layer thickness" means the sum of the thicknesses of these layers. If the average layer thickness is less than 0.5 μm, the wear resistance cannot be improved under high-temperature cutting conditions. On the other hand, if the average layer thickness is more than 20 μm, although the increased thickness improves the wear resistance, the breakage resistance cannot be improved. As a result, the tool life is decreased. In addition, if the average layer thickness is less than one-half the average total thickness of the coating (constituting ratio of the first compound layer: less than 0.5) or the first compound layer has a granular structure, the intended improvement of the wear resistance cannot be achieved.

To form a columnar structure in the first compound layer, it is recommendable that the material gas comprise organic carbonitride, such as $CH_3CN$, which facilitates the formation of the columnar structure. In addition, as described above, when the temperature of the reaction atmosphere is controlled to be at least 700 °C and at most 1,000 °C, and the pressure of the reaction atmosphere is controlled to be at least 5 kPa and at most 20 kPa, the columnar structure can be formed in the first compound layer. When a gas other than the organic carbonitride is used, it is recommendable to increase the film-forming speed, to raise the film-forming temperature, or to increase the concentration of the material gas.

Furthermore, the present inventors found that when the first compound layer made of the foregoing oxycarbonitride has a specific crystal orientation, not only the wear resistance but also the mechanical strength of the layer can be improved even under harsh cutting conditions that the cutting part is subjected to high temperatures. Accordingly, the present invention specifies the crystal orientation. More specifically, the crystal of the first compound layer is required to have the maximum value of the orientational texture coefficient TC (coefficient of texture orientation intensity) that lies in one of the crystal growth orientations of the (220), (311), and (422) planes out of the (111), (200), (220), (311), (331), (420), (422), and (511) planes. The orientational texture coefficient TC is defined as Eq. 1 below.

$$TC(hkl) = \frac{I(hkl)}{I_0(hkl)} \left\{ \frac{1}{8} \sum \frac{I(hkl)}{I_0(hkl)} \right\}^{-1} \quad \ldots \text{Equation 1,}$$

where $I(hkl)$: the measured diffraction intensity at the $(hkl)$ plane,

$I_0(hkl)$: the average value of the powder diffraction intensities of the carbide and nitride of the metal constituting the $(hkl)$ plane, in accordance with the JCPDS file, and

$(hkl)$: the following eight planes: (111), (200), (220), (311), (331), (420), (422), and (511) planes.

In the above expression, "JCPDS" is the abbreviation of "Joint Committee on Powder Diffraction Standard," and "JCPDS file" means "Powder Diffraction File Published by JCPDS International Center for Diffraction Data."

To allocate the maximum value at one of the orientational texture coefficients of the (220), (311), and (422) planes in the crystal growth orientation, it is recommendable to properly control the conditions for forming the first compound layer, such as the temperature and pressure for film formation, gas composition, gas-flow velocity, and gas-flow rate. Another method to be recommended is to properly control the surface condition of the member directly beneath the first compound layer, whether it is the substrate or another compound layer. More specifically, for example, over the substrate that is controlled to have a surface roughness of at least 0.05 μm and at most 1.5 μm, the first compound layer may be formed by properly controlling the film-forming conditions. As another example, over another compound layer that is controlled to have a proper surface roughness, chemical condition of the crystal grains, and grain size, the first compound layer may be formed by properly controlling the film-forming conditions.

It is recommendable to measure the diffraction intensity at a flat portion of the substrate to avoid the reflection of X-rays by the uneven surface of the substrate. The JCPDS file has no data of the X-ray diffraction intensities on oxycarbonitride of the metals belonging to the IVa, Va, and VIa groups in the periodic table. However, the identification of the oxycarbonitride in the first compound layer by the diffraction intensity can be performed by the following method. First, the measured diffraction data of the oxycarbonitride of the metal belonging to the IVa, V a, or VIa group in the periodic table are compared with the file's diffraction data of the carbide and nitride of the metal belonging to the IVa, Va, or VIa group in the periodic table. This comparison enables the estimation of individual Miller indexes. Finally, the diffraction intensity at each Miller index can be read.

The metal belonging to the IVa, Va, or VIa group in the periodic table to be used for the first compound layer is not limited to one type. To the main metal element, another metal element may be added as a subelement. In this case, it is desirable that the atomic ratio of the subelement to the main element be at most 40%. For example, $(Ti_{70}W_{30})$ CNO may be employed, where the numerals denote the atomic ratios.

In order to further increase the wear resistance to increase the tool life, it is desirable that the first compound layer have a columnar structure having an aspect ratio of at least three. If the aspect ratio is less than three, the wear resistance tends to decrease under the high-temperature cutting condition. It is also desirable that the first compound layer have a crystal structure in which the crystal has an average grain diameter of at least 0.05 μm and at most 1.5 μm. If the average grain diameter is less than 0.05 μm, the first compound layer cannot have high crystallinity. As a result, the bonding strength between the crystal grains constituting the layer becomes low, so that the layer has difficulty in maintaining its form. Consequently, the layer cannot have enough wear resistance. On the other hand, if the average grain diameter is more than 1.5 μm, the surface unevenness of the first compound layer becomes excessive. As a result, the frictional resistance with the workpiece increases, increasing the possibility of the occurrence of abnormally high cutting temperatures. Consequently, the layer cannot have excellent wear resistance.

In order to achieve the specified aspect ratio and crystal-grain diameter, it is recommendable to grow a columnar structure while maintaining a small average grain diameter as a basic method. More specifically, it is recommendable to properly control the conditions for forming the first compound layer, such as the temperature and pressure for film formation, gas composition, gas-flow velocity, and gas-flow rate. Another method to be recommended is to properly control the surface condition of the member directly beneath the first compound layer, whether it is the substrate or another compound layer. More specifically, for example, over the substrate that is controlled to have a surface roughness of at least 0.05 µm and at most 1.5 µm, the first compound layer may be formed by properly controlling the film-forming conditions. As another example, over another compound layer that is controlled to have a proper surface roughness, chemical condition of the crystal grains, and grain size (particularly at least 0.01 µm and at most 1.0 µm), the first compound layer may be formed by properly controlling the film-forming conditions.

The aspect ratio can be measured by the following method, for example. First, a perpendicularly cut surface of the coating is mirror-finished. Then, the surface is etched to clarify the grain boundaries of the columnar structure in the first compound layer. The width of each crystal is measured at the thicknesswise center of the or each layer of the first compound layer in a direction parallel to the surface of the substrate. The width is assumed to be the diameter of the crystal grain. The measured results of individual crystal grains are averaged to obtain the average crystal-grain diameter. The thickness of the layer is divided by the average crystal-grain diameter to obtain the aspect ratio.

As described above, the coating comprises a first compound layer that comprises at least one layer. The coating, however, may comprise in addition to the first compound layer a second compound layer comprising at least one layer composed of a material selected from the group consisting of (a) carbide, nitride, carbonitride, boride, boronitride, borocarbonitride, oxyboronitride, oxide, oxycarbide, oxynitride, and oxycarbonitride of the metals belonging to the IVa, Va, and VIa groups in the periodic table; (b) aluminum oxide; and (c) a solid solution of these. In the above group, the oxycarbonitride having the same atomic ratios as those of the first compound layer is excluded. In this case, it is desirable that the coating comprising the first and second compound layers have an average total thickness of at least 1.0 µm and at most 30.0 µm. This structure enables further improvement of the wear resistance. If the average total thickness is less than 1.0 µm, the wear resistance cannot be effectively improved. On the other hand, if the average total thickness is more than 30.0 µm, although the increased thickness improves the wear resistance, the hardness is increased. The increased hardness reduces the breakage resistance. As a result, the tool life tends to be decreased. The oxycarbonitride layer constituting the second compound layer mainly has a granular structure.

In the present invention, the coating may comprise the following members:

(a) a titanium nitride layer formed as the innermost layer over the surface of the hard-alloy substrate;
(b) the first compound layer comprising at least two layers formed at the outside of the titanium nitride layer; and
(c) the second compound layer comprising at least one layer formed at the outside of the first compound layer.

Titanium nitride can bond to the hard-alloy substrate with high strength. Therefore, it is desirable to use it as the innermost layer. The coating having the foregoing structure can have improved wear resistance even under harsher cutting conditions and environments. Consequently, the coating can have an increased useful life. In the above-described coating structure, the first compound layer may be formed either immediately over the titanium nitride layer or through another compound layer. Similarly, the second compound layer may be formed either immediately over the first compound layer or through another compound layer.

In the present invention, the coating may further comprise the following members:

(a) a titanium compound layer that:

(a1) comprises at least one layer made of a material selected from the group consisting of titanium boronitride and titanium oxyboronitride; and
(a2) is formed immediately over the first compound layer;

(b) an oxide layer that:

(b1) comprises at least one layer made of a material selected from the group consisting of aluminum oxide, zirconium oxide, and a solid solution of these; and
(b2) is formed immediately over the titanium compound layer; and

(c) a compound layer that:

(c1) is made of a material selected from the group consisting of carbide, nitride, carbonitride, oxycarbide, oxynitride, and oxycarbonitride (except the oxycarbonitride having the same atomic ratios as those of the first compound layer) of the metals belonging to the IVa, V a, and VIa groups in the periodic table; and
(c2) is formed at the outermost position of the coating.

The titanium compound layer is provided immediately over the first compound layer to improve the bonding strength between the first compound layer and the oxide layer. The oxide layer is provided immediately over the titanium compound layer to improve the chemical stability of the layers underneath because it can suppress the oxidation of the layers and has excellent thermal stability. The outermost compound layer is provided to identify the used corner, to dress the cutting tool, and to exploit its good chemical stability. It may be made of a material such as TiN, TiCN, ZrC, HfC, and HfN. In particular, a TiN layer not only has low reactivity with the workpiece made of a material such as iron and superior adhesion resistance but also functions as a gold-tinted layer, which facilitates the identification of the used corner of the cutting tool. The coating having the above-described structure can reinforce the bonding strength between the layers. As a result, the coating can have not only improved wear resistance but also improved spalling resistance even under harsher cutting conditions and environments. Consequently, the coating can have an increased useful life.

The above-described second compound layer, titanium nitride layer, titanium compound layer, oxide layer, and outermost compound layer may be formed by the well-known CVD or PVD method. The method includes the hot-filament CVD method, plasma CVD method, reaction magnetron sputtering method, and ion-plating method.

In the present invention, the hard-alloy substrate may be made of well-known hard alloy, such as cemented carbide based on tungsten carbide, cermet alloy, ceramic, cBN, and other alloys for cutting use. As with the conventional cutting tool, the cutting-edge portion of the coated cutting tool of the present invention may be surface-treated by a polishing or laser treatment after the above-described coating is formed over the surface of the substrate. The surface treatment can be performed without a noticeable deleterious effect on the properties of the coating.

As explained above, the present invention is particularly effective in offering a coated cutting tool having excellent wear resistance even under the working condition that the cutting part is subjected to high temperatures resulting from high-speed, high-efficiency machining. As a result, the coated cutting tool can have a further increased tool life.

Embodiments of the present invention are explained below.

(Example 1)

The hard-alloy substrate was produced by the following process. First, the following material powders were prepared with the indicated weight percentage: 87% WC, 1% TiC, 3% NbC, 1% ZrC, and 8% Co. The powders were wet-mixed with a ball mill for 72 hours. The mixed powders were dried and formed with a press into a green compact. The green compact had the shape of an indexable insert with chip breakers expressed as ISO SNMG120408. The green compact was placed in a sintering furnace to be sintered at 1,400 °C in an atmosphere under vacuum for two hours. The sintered body was subjected to a honing treatment to obtain the cemented-carbide substrate. Over the obtained substrate, various types of first compound layers made of oxycarbonitride of metals belonging to the IVa, Va, and VIa groups in the periodic table were formed by using a CVD apparatus under the conditions shown in Table I. In Table I, the title of the column "amount of $H_2O$" means the volume ratio of $H_2O$ to $CH_3CN$. Table II shows the forming conditions for other compound layers than the first compound layer. Various samples were produced as shown in Table III. Table III shows the constitution of the coating, average thickness of each layer, average total thickness of the coating (shortened as "total thickness"), ratio of the average layer thickness of the first compound layer to the average total thickness of the coating (shortened as "constituting ratio), aspect ratio, average diameter of the crystal grains (shortened as "grain diameter"), and plane at which the maximum orientational texture coefficient of the first compound layer lies (shortened as "plane of max. TC"). In Table III, the symbols "*a*" to "*1*" show the types of first compound layers shown in Table I.

Table I

| First compound layer | | Composition of reaction gas | Amount of H₂O(*) | Reaction atmosphere | |
| --- | --- | --- | --- | --- | --- |
| Type | Composition | volume % | | Temperature (°C) | Pressure (kPa) |
| a | $Ti(C_{0.68}N_{0.25}O_{0.07})$ | TiCl₄: 2%, CH₃CN: 2.0%, N₂: 20%, Ar: 2%, H₂: remainder | 0.130 | 900 | 6.7 |
| b | $Ti(C_{0.49}N_{0.35}O_{0.16})$ | TiCl₄: 2%, CH₃CN: 1.5%, N₂: 20%, Ar: 2%, H₂: remainder | 0.500 | 900 | 6.7 |
| c | $Ti(C_{0.38}N_{0.33}O_{0.29})$ | TiCl₄: 2%, CH₃CN: 0.9%, N₂: 15%, CO: 1%, H₂: remainder | 1.500 | 800 | 13.3 |
| d | $Ti(C_{0.57}N_{0.40}O_{0.03})$ | TiCl₄: 2%, CH₃CN: 1.2%, N₂: 30%, Ar: 1%, H₂: remainder | 0.001 | 950 | 80 |
| e | $Ti(C_{0.29}N_{0.33}O_{0.38})$ | TiCl₄: 2%, CH₃CN: 0.7%, N₂: 30%, CO: 4%, H₂: remainder | 0.001 | 1,000 | 80 |
| f | $Ti(C_{0.40}N_{0.40}O_{0.20})$ | TiCl₄: 2%, CH₃CN: 1.0%, N₂: 30%, Ar: 1%, H₂: remainder | 0.001 | 980 | 80 |
| g | $Ti(C_{0.34}N_{0.33}O_{0.33})$ | TiCl₄: 2%, CH₃CN: 0.3%, N₂: 40%, Ar: 1%, H₂: remainder | 9.500 | 1,000 | 80 |
| h | $Zr(C_{0.50}N_{0.30}O_{0.20})$ | ZrCl₄: 2%, CH₃CN: 5.0%, N₂: 30%, Ar: 3%, H₂: remainder | 4.100 | 980 | 20 |
| i | $Zr(C_{0.80}N_{0.13}O_{0.07})$ | ZrCl₄: 2%, CH₃CN: 9.5%, N₂: 5%, Ar: 2%, H₂: remainder | 0.008 | 1,050 | 4 |
| j | $TiZr(C_{0.60}N_{0.30}O_{0.20})$ | TiCl₄: 1%, ZrCl₄: 0.6%, CH₃CN: 4.3%, N₂: 25%, , H₂: remainder | 3.500 | 980 | 20 |
| k | $V(C_{0.50}N_{0.30}O_{0.20})$ | VCl₄: 2%, CH₃CN: 5.0%, N₂: 30%, Ar: 2%, H₂: remainder | 4.000 | 800 | 15 |
| l | $V(C_{0.30}N_{0.42}O_{0.28})$ | VCl₄: 2%, CH₃CN: 0.5%, N₂: 50%, Ar: 2%, H₂: remainder | 9.800 | 800 | 15 |

(*): Volume percent of H₂O to CH₃CN

Examples d, e, g, i, j, l are comparative.

Table II

| Composition of coating | Composition of reaction gas (volume %) | Reaction atmosphere | |
|---|---|---|---|
| | | Temperature (℃) | Pressure (kPa) |
| TiN | $TiCl_4$: 4%, $N_2$: 35%, $H_2$: remainder | 900 | 30 |
| Granular TiCN | $TiCl_4$: 4%, $CH_4$: 4%, $N_2$: 20%, $H_2$: remainder | 1,020 | 14 |
| Columnar TiCN | $TiCl_4$: 4%, $CH_3CN$: 0.6%, $N_2$: 20%, $H_2$: remainder | 800 | 7 |
| TiC | $TiCl_4$: 4%, $CH_4$: 8%, Ar: 20%, $H_2$: remainder | 1,020 | 7 |
| TiCO | $TiCl_4$: 4%, CO: 4%, $H_2$: remainder | 1,020 | 7 |
| Granular TiCNO | $TiCl_4$: 4%, CO: 3%, $CH_4$: 3%, $N_2$: 20%, $H_2$: remainder | 1,020 | 14 |
| TiBN | $TiCl_4$: 4%, $BCl_3$: 5%, $N_2$: 5%, $H_2$: remainder | 1,020 | 30 |
| $\kappa$-type $Al_2O_3$ | $AlCl_3$: 2%, $CO_2$: 5%, HCl: 2%, $H_2S$: 0.3%, $H_2$: remainder | 950 | 7 |
| $\alpha$-type $Al_2O_3$ | $AlCl_3$: 3%, $CO_2$: 5%, HCl: 2%, $H_2S$: 0.3%, $H_2$: remainder | 1,050 | 7 |

EP 1 413 648 B1

Table II

| Sample No. | Constitution of the coating (average layer thickness in μm) | | | | | | Total thickness[1] (μm) | Constituting ratio[2] | Aspect ratio | Grain diameter[3] (μm) | Plane of max. TC[4] | Cutting performance (Workable time) |
|---|---|---|---|---|---|---|---|---|---|---|---|---|
| | 1st layer | 2nd layer | 3rd layer | 4th layer | 5th layer | 6th layer | | | | | | |
| 1 | a(2) | - | - | - | - | - | 2.0 | 1.00 | 6.7 | 0.3 | 311 | 20 |
| 2 | b(18) | - | - | - | - | - | 18.0 | 1.00 | 36 | 0.5 | 422 | 25 |
| 3 | TiN(1) | b(15) | - | - | - | - | 16.0 | 0.93 | 30 | 0.5 | 422 | 43 |
| 4 | TiC(2) | TiBN(0.7) | c(7) | TiN(0.5) | - | - | 10.2 | 0.69 | 70 | 0.1 | 422 | 50 |
| 5 | TiN(0.1) | Granular TiCN(0.3) | h(2.6) | TiCNO(0.4) | κ-type Al₂O₃(1.3) | TiN(0.3) | 5.0 | 0.52 | 3.3 | 0.8 | 220 | 30 |
| 6 | j(15) | ZrC(2) | α-type Al₂O₃(5) | TiCO(1) | TiN(2) | - | 25.0 | 0.60 | 10.7 | 1.4 | 220 | 45 |
| 7 | TiN(1) | Columnar TiCN(0.5) | k(9) | κ-type Al₂O₃(1.5) | TiN(0.5) | - | 12.5 | 0.72 | 150 | 0.06 | 422 | 40 |
| 8 | TiN(0.5) | h(4) | TiN(0.5) | α-type Al₂O₃(1) | TiCO(0.5) | TiN(0.5) | 7.0 | 0.57 | 5 | 0.8 | 220 | 30 |
| 9 | TiN(0.5) | b(7) | TiBN(0.4) | κ-type Al₂O₃(1.5) | TiN(0.5) | - | 9.9 | 0.71 | 14 | 0.5 | 422 | 47 |
| 10 | TiN(0.5) | a(1) | b(7) | Granular TiCNO(0.4) | κ-type Al₂O₃(1.5) | TiN(0.5) | 10.9 | 0.73 | 16 | 0.5 | 422 | 50 |
| 11 | a(0.3) | - | - | - | - | - | 0.3 | 1.00 | 1.0 | 0.3 | 311 | 5 |
| 12 | d(18) | - | - | - | - | - | 18.0 | 1.00 | 9 | 2 | 220 | 9 |
| 13 | f(22) | - | - | - | - | - | 22.0 | 1.00 | 22 | 1 | 111 | 10 |
| 14 | TiC(8) | TiBN(8) | e(15) | TiN(3) | - | - | 34.0 | 0.44 | 18.8 | 0.8 | 422 | 12 |
| 15 | TiC(2) | TiBN(0.7) | g(7) | TiN(0.5) | - | - | 10.2 | 0.69 | 14 | 0.5 | 200 | 7 |
| 16 | TiC(2) | TiN(1) | a(1) | TiN(1) | TiCO(2) | - | 7.0 | 0.14 | 3.3 | 0.3 | 311 | 8 |
| 17 | TiN(0.5) | i(4) | TiN(0.5) | α-type Al₂O₃(1) | TiCO(0.5) | TiN(0.5) | 7.0 | 0.57 | 5.7 | 0.7 | 200 | 9 |
| 18 | TiC(2) | TiBN(0.7) | l(7) | TiN(0.5) | - | - | 10.2 | 0.69 | 233 | 0.03 | 422 | 7 |
| 19 | Granular TiCN(18) | - | - | - | - | - | 18.0 | - | - | - | - | 0.5 |
| 20 | TiN(1) | Columnar TiCN(10) | κ-type Al₂O₃(1.5) | TiN(0.5) | - | - | 13.0 | - | - | - | - | 1 |
| 21 | TiN(1) | ZrC(5) | α-type Al₂O₃(5) | TiCO(5) | TiN(1) | - | 19.0 | - | - | - | - | 0.8 |

(1) Average total thickness of the coating
(2) Ratio of the average layer thickness of the first compound layer to the average total thickness of the coating
(3) Average diameter of the crystal grains
(4) Plane at which the maximum orientational tissue coefficient of the first compound layer lies

Samples 11 – 21 are comparative.

In this example, Samples 1, 2, 11, 12, and 13 were produced by changing the surface roughness of the substrate from 0.05 μm to 1.5 μm. Similarly, Samples 3 to 10 and 14 to 18 were produced by changing the surface roughness of the member immediately underneath the first compound layer, whether it is the substrate or another compound layer, from 0.01 μm to 1.0 μm. These changes changed the aspect ratio and the plane at which the maximum orientational tissue coefficient lies. All of the first compound layers made of oxycarbonitride had a columnar structure.

The coated cutting tools shown in Table III were subjected to a cutting test under the conditions described below to evaluate the cutting performance. The cutting performance was evaluated by the workable time until the tool reaches the end of its useful life. The end of the tool life was judged by the moment when the tool's substrate was fractured or when the width of a flank wear exceeded 0.3 mm. The test results are also shown in Table III.

(Cutting conditions)

Cutting method: continuous cutting
Workpiece: JIS SCM435, round bar
Cutting speed: 400 m/min
Feed: 0.30 mm/rev.
Depth of cut: 1.8 mm
Cutting time: workable time until the tool reaches the end of its useful life
Cutting fluid: not used

As can be seen from Table III, Samples 1 to 10, whose first compound layers satisfied the following conditions, had a considerably longer tool life than that of Samples 19 to 21, which were produced under the conventional film-forming condition:

(a)

$$x > y > z \text{ and } x + y + z = 1$$

$$0.74 > x > 0.35, 0.45 > y > 0.20, \text{ and } 0.30 > z > 0.06;$$

(b) the average layer thickness is at least 0.5 μm and at most 20 μm, and the thickness constitutes at least one-half the average total thickness of the coating;
(c) the layer has a columnar structure; and
(d) in the crystal structure, the largest orientational texture coefficient lies at one of the (220), (311), and (422) planes.

The test results also showed that Samples 1 to 10 had a longer tool life than that of Samples 11 to 18, which failed to satisfy the conditions (a) to (d) listed above. The present inventors believe that the above result was obtained because Samples 1 to 10 had the first compound layer that satisfied the conditions (a) to (d) above and therefore had an improved wear resistance, in particular. Consequently, the coated cutting tool of the present invention has excellent wear resistance even under the working condition that the cutting part is subjected to high temperatures resulting from high-speed, highefficiency machining or dry cutting. The tool also has an excellent chipping resistance and breakage resistance in the cutting part under the same condition. As a result, the tool has an increased tool life.

In particular, Sample 2, which satisfied the condition $0.62 > x > 0.40, 0.40 > y > 0.25, \text{ and } 0.20 > z > 0.13$, had a better wear resistance than that of Sample 1, which satisfied the condition (a). Samples 3 to 10, which had the second compound layer in addition to the first compound layer, had more outstanding wear resistance, showing a longer tool life. Of Samples 3 to 10, the following two samples had particularly noticeable wear resistance, showing a longer tool life:

Sample 10: it had a titanium nitride layer at the innermost position, the first compound layer composed of two layers having different atomic compositions, and the second compound layer, in this order in succession.
Sample 9: it had a titanium nitride layer at the innermost position, the first compound layer, a titanium boronitride layer, an aluminum oxide layer, and a titanium nitride layer at the outermost position, in this order in succession.

(Example 2)

The following samples of cutting tools were produced by coating different types of substrates with the same coating used in Sample 9 in Example 1 under the same conditions as in Example 1: Sample 2-1 having a cermet-alloy substrate, Sample 2-2 having a ceramic substrate, and Sample 2-3 having a cBN substrate. The samples were subjected to a cutting test under the conditions described below to evaluate the cutting performance. The cutting performance was evaluated by the same method as used in Example 1. For comparison, Sample 20 in Example 1 was also subjected to the same cutting test to evaluate the cutting performance.

The cermet-alloy substrate of Sample 2-1 was produced by the following process. First, the following material powders were prepared with the indicated weight percentage: 22% TiCN, 5% TaC, 4% NbC, 7% Co, 10% Ni, and TiC constituting the remaining part. The powders were wet-mixed with a ball mill for 10 hours. The mixed powders were dried and formed with a press into a green compact. The green compact had the shape of an indexable insert with chip breakers expressed as ISO SNMG120408. The green compact was placed in a sintering furnace to be sintered at 1,500 °C in an atmosphere under vacuum for one hour. The sintered body was subjected to a honing treatment to obtain the cermet-alloy substrate.

The ceramic substrate of Sample 2-2 was produced by the following process. First, the following material powders were prepared with the indicated weight percentage: 74% $Al_2O_3$, 24% $ZrO_2$, 1% MgO, and 1% CaO. The powders were mixed together with a solvent containing a high-molecule electrolyte and pulverized with a rotary mill for 72 hours. A binder was added to and mixed with the obtained slurry. The mixed slurry was dried and formed with a press into a green compact. The green compact had the shape of an indexable insert expressed as ISO SNMG120408. The green compact was sintered at 1,600 °C in the atmosphere under atmospheric pressure for 260 minutes. The sintered body was subjected to a hot isostatic pressing (HIP) treatment in an inert gas at 1,550 °C and at 150 MPa for two hours to obtain a ceramic body. The ceramic body was treated by honing to obtain the ceramic substrate.

The cBN substrate of Sample 2-3 was produced by the following process. First, the following material powders were prepared: a binder powder composed of 40 wt. % TiN and 10 wt. % Al and a 50 wt. % cBN powder having an average particle diameter of 2.5 μm. The powders were mixed by using a pot and balls both made of cemented carbide. The mixed powders were packed in a cemented-carbide container to be sintered at a temperature of 1,400 °C and at a pressure of 5 GPa for 60 minutes. The cBN sintered body was processed to obtain an indexable insert for cutting use having the shape of ISO SNGA120408.

(Cutting conditions)

Cutting method: interrupted cutting
Workpiece: JIS SCM435, round bar with two grooves
Cutting speed: 300 m/min
Feed: 0.4 mm/rev.
Depth of cut: 2.5 mm
Cutting time: workable time until the tool reaches the end of its useful life
Cutting fluid: not used

The cutting test result showed that whereas Sample 20 had a workable time of 0.5 minute, Samples 2-1 to 2-3 had a workable time of more than 10 minutes. The result confirmed that the samples of this example had excellent wear resistance even under harsher cutting conditions, such as high-speed, high-rate feeding interrupted cutting, showing that they have an increased tool life.

**Claims**

**1.** A coated cutting tool comprising a hard-alloy substrate and a coating formed over the substrate, the coating comprising a first compound layer that:

(a) comprises at least one layer; and
(b) has an average layer thickness of at least 0.5 μm and at most 20 μm, the thickness constituting at least one-half the average total thickness of the coating;
the at least one layer being made of oxycarbonitride of a metal belonging to one of the IVa, Va, and VIa groups in the periodic table to which optionally another metal element may be added as a subelement;
the at least one layer having:
(c) atomic ratios of carbon, nitrogen, and oxygen, expressed as *x, y,* and *z*, respectively, that satisfy the following

formulae:

$$x > y > z \text{ and } x + y + z = 1$$

$$0.74 > x > 0.35, 0.45 > y > 0.20, \text{ and } 0.30 > z > 0.06;$$

(d) a columnar structure; and
(e) in the crystal structure, the largest orientational texture coefficient that lies in one of the orientational texture coefficients TC(220), TC(311), and TC(422) at the (220), (311), and (422) planes, respectively.

**2.** A coated cutting tool as defined by claim 1, wherein the at least one layer has atomic ratios that satisfy the following formulae:

$$0.62 > x > 0.40, 0.40 > y > 0.25, \text{ and } 0.20 > z > 0.13.$$

**3.** A coated cutting tool as defined by claim 1 or 2, wherein:

(a) the columnar structure has an aspect ratio of at least three; and
(b) the crystal has an average grain diameter of at least 0.05 µm and at most 1.5 µm.

**4.** A coated cutting tool as defined by any of claims 1 to 3, wherein:

(a) the coating further comprises a second compound layer comprising at least one layer made of a material selected from the group consisting of:

(a1) carbide, nitride, carbonitride, boride, boronitride, borocarbonitride, oxyboronitride, oxide, oxycarbide, oxynitride, and oxycarbonitride (except the oxycarbonitride having the same atomic ratios as those of the first compound layer) of the metals belonging to the IVa, Va, and VIa groups in the periodic table;
(a2) aluminum oxide; and
(a3) a solid solution of these; and

(b) the coating has an average total thickness of at least 1.0 µm and at most 30 µm.

**5.** A coated cutting tool as defined by claim 4, wherein the coating comprises:

(a) a titanium nitride layer formed as the innermost layer over the surface of the hard-alloy substrate;
(b) the first compound layer comprising at least two layers formed at the outside of the titanium nitride layer; and
(c) the second compound layer comprising at least one layer formed at the outside of the first compound layer.

**6.** A coated cutting tool as defined by any of claims 1 to 5, wherein the coating further comprises:

(a) a titanium compound layer that:

(a1) comprises at least one layer made of a material selected from the group consisting of titanium boronitride and titanium oxyboronitride; and
(a2) is formed immediately over the first compound layer;

(b) an oxide layer that:

(b1) comprises at least one layer made of a material selected from the group consisting of aluminum oxide, zirconium oxide, and a solid solution of these; and
(b2) is formed immediately over the titanium compound layer; and

(c) a compound layer that:

(c1) is made of a material selected from the group consisting of carbide, nitride, carbonitride, oxycarbide, oxynitride, and oxycarbonitride (except the oxycarbonitride having the same atomic ratios as those of the first compound layer) of the metals belonging to the IVa, Va, and VIa groups in the periodic table; and
(c2) is formed at the outermost position of the coating.

**Patentansprüche**

1. Beschichtetes Schneidwerkzeug, das einen Hartlegierungsträger und eine Beschichtung umfasst, die über dem Träger ausgebildet ist, wobei die Beschichtung eine erste Verbundschicht umfasst, die:

   (a) wenigstens eine Schicht umfasst; und

   (b) eine durchschnittliche Schichtdicke von wenigstens 0,5 μm und höchstens 20 μm hat, wobei die Dicke wenigstens eine Hälfte der durchschnittlichen Gesamtdicke der Beschichtung bildet;
   die wenigstens eine Schicht aus Oxy-Karbonitrid eines Metalls besteht, das zu einer der Gruppen IVa, Va und VIa im Periodensystem der Elemente gehört und dem wahlweise ein anderes Metallelement als Teilelement zugesetzt werden kann;
   wobei die wenigstens eine Schicht aufweist:

   (c) Atomverhältnisse von Kohlenstoff, Stickstoff und Sauerstoff, die als $x$, $y$ bzw. $z$ ausgedrückt werden und die folgenden Gleichungen erfüllen:

$$x > y > z \text{ und } x + y + z = 1$$

$$0{,}74 > x > 0{,}35, \ 0{,}45 > y > 0{,}20, \text{ und } 0{,}30 > z > 0{,}06;$$

   (d) eine säulenartige Struktur; und

   (e) in der Kristallstruktur den größten Orientierungstextur-Koeffizienten, der in einem der Orientierungstextur-Koeffizienten TC(220), TC(311) und TC(422) in der (220)-, (311)- bzw. (422)-Ebene liegt.

2. Beschichtetes Schneidwerkzeug nach Anspruch 1, wobei die wenigstens eine Schicht Atomverhältnisse hat, die die folgende Formel erfüllen:

$$0{,}62 > x > 0{,}40, \ 0{,}40 > y > 0{,}25, \text{ und } 0{,}20 > z > 0{,}13.$$

3. Beschichtetes Schneidwerkzeug nach Anspruch 1 oder 2, wobei:

   (a) die säulenartige Struktur ein Seitenverhältnis von wenigstens 3 hat; und

   (b) der Kristall einen durchschnittlichen Korndurchmesser von wenigstens 0,05 μm und höchstens 1,5 μm hat.

4. Beschichtetes Schneidwerkzeug nach einem der Ansprüche 1 bis 3, wobei:

   (a) die Beschichtung des Weiteren eine zweite Verbundschicht umfasst, die wenigstens eine Schicht umfasst, die aus einem Material besteht, das aus der Gruppe ausgewählt wird, die besteht aus:

   (a1) Carbid, Nitrid, Karbonitrid, Borid, Bornitrid, Bor-Karbonitrid, Oxy-Bornitrid, Oxid, Oxykarbid, Oxynitrid und Oxy-Karbonitrid (mit Ausnahme des Oxy-Karbonitrids, das die gleichen Atomverhältnisse wie die der ersten Verbundschicht hat) der Metalle, die zu den Gruppen IVa, Va und VIa im Periodensystem der Elemente gehören;

   (a2) Aluminiumoxid; und

(a3) eine feste Lösung derselben; und

(b) die Beschichtung eine durchschnittliche Gesamtdicke von wenigstens 1,0 µm und höchstens 30 µm hat.

**5.** Beschichtetes Schneidwerkzeug nach Anspruch 4, wobei die Beschichtung umfasst:

(a) eine Titannitridschicht, die als die innerste Schicht über der Oberfläche des Hartlegierungsträgers ausgebildet ist;

(b) die erste Verbundschicht, die wenigstens zwei Schichten umfasst, die an der Außenseite der Titannitridschicht ausgebildet sind; und

(c) die zweite Verbundschicht, die wenigstens eine Schicht umfasst, die an der Außenseite der ersten Verbundschicht ausgebildet ist.

**6.** Beschichtetes Schneidwerkzeug nach einem der Ansprüche 1 bis 5, wobei die Beschichtung des Weiteren umfasst:

(a) eine Titan-Verbundschicht, die:

(a1) wenigstens eine Schicht umfasst, die aus einem Material besteht, das aus der Gruppe ausgewählt wird, die aus Titan-Bornitrid und Titan-Oxy-Bornitrid besteht; und

(a2) unmittelbar über der ersten Verbundschicht ausgebildet ist;

(b) eine Oxidschicht, die:

(b1) wenigstens eine Schicht umfasst, die aus einem Material besteht, das aus der Gruppe ausgewählt wird, die aus Aluminiumoxid, Zirkonoxid und einer festen Lösung derselben besteht; und

(b2) unmittelbar über der Titan-Verbundschicht ausgebildet ist; und

(c) eine Verbundschicht, die:

(c1) aus einem Material besteht, das aus der Gruppe ausgewählt wird, die aus Karbid, Nitrid, Karbonitrid, Oxykarbid, Oxynitrid und Oxy-Karbonitrid (bis auf das Oxy-Carbonitrid, das die gleichen Atomverhältnisse wie die der ersten Verbundschicht hat) der Metalle besteht, die zu den Gruppen IVa, Va und VIa im Periodensystem gehören; und

(c2) an der äußersten Position der Beschichtung ausgebildet ist.

**Revendications**

**1.** Outil coupant revêtu comprenant un substrat en alliage dur et un revêtement formé sur le substrat, le revêtement comprenant une couche d'un premier composé qui :

(a) comprend au moins une couche ; et
(b) a une épaisseur moyenne de couche d'au moins 0,5 µm et d'au plus 20 µm, l'épaisseur constituant au moins la moitié de l'épaisseur moyenne totale du revêtement ;
    la, au moins une couche étant formée d'oxycarbonitrure d'un métal appartenant à l'un des groupes IVa, Va et VIa du tableau périodique, auquel, facultativement, un autre élément métallique peut être ajouté en tant qu'élément secondaire ;
    la, au moins une, couche ayant :
(c) des rapports atomiques du carbone, de l'azote et de l'oxygène, exprimés par x, y et z, respectivement, qui satisfont aux formules suivantes :

$$x > y > z \text{ et } x + y + z = 1$$

$$0,74 > x > 0,35, \ 0,45 > y > 0,20 \text{ et } 0,30 > z >$$

0,06 ;

(d) une structure en colonne ; et

(e) dans la structure du cristal, le coefficient de texture d'orientation le plus grand qui est compris dans l'un des coefficients de texture d'orientation TC(220), TC(311) et TC(422) aux plans (220), (311), (422), respectivement.

2. Outil coupant revêtu selon la revendication 1, dans lequel la, au moins une, couche a des rapports atomiques qui satisfont aux formules suivantes :

$$0,62 > x > 0,40, \ 0,40 > y > 0,25 \text{ et } 0,20 > z > 0,13.$$

3. Outil coupant revêtu selon la revendication 1 ou 2, dans lequel :

(a) la structure en colonne a un rapport d'aspect d'au moins trois ; et
(b) le cristal a un diamètre moyen de grain d'au moins 0,05 µm et d'au plus 1,5 µm.

4. Outil coupant revêtu selon l'une quelconque des revendications 1 à 3, dans lequel :

(a) le revêtement comprend en outre une couche d'un second composé comprenant au moins une couche formée d'une matière choisie dans le groupe constitué de :

(a1) un carbure, un nitrure, un carbonitrure, un borure, un boronitrure, un borocarbonitrure, un oxyboronitrure, un oxyde, un oxycarbure, un oxynitrure et un oxycarbonitrure (à l'exception de l'oxycarbonitrure ayant les mêmes rapports atomiques que ceux de la couche du premier composé) des métaux appartenant aux groupes IVa, Va et VIa du tableau périodique ;
(a2) un oxyde d'aluminium ; et
(a3) une solution solide de ceux-ci ; et

(b) le revêtement a une épaisseur totale moyenne d'au moins 1,0 µm et d'au plus 30 µm.

5. Outil coupant revêtu selon la revendication 4, dans lequel le revêtement comporte :

(a) une couche de nitrure de titane formée en tant que couche située le plus à l'intérieur sur la surface du substrat en alliage dur ;
(b) la couche du premier composé comprenant au moins deux couches formées sur le côté extérieur de la couche de nitrure de titane ; et
(c) la couche du second composé comprenant au moins une couche formée sur le côté extérieur de la couche du premier composé.

6. Outil coupant revêtu selon l'une quelconque des revendications 1 à 5, dans lequel le revêtement comporte en outre :

(a) une couche d'un composé de titane qui :

(a1) comprend au moins une couche formée d'une matière choisie dans le groupe constitué de boronitrure de titane et de l'oxyboronitrure de titane ; et
(a2) est formée immédiatement sur la couche du premier composé ;

(b) une couche d'oxyde qui :

(b1) comprend au moins une couche formée d'une matière choisie dans le groupe constitué d'oxyde d'aluminium, d'oxyde de zirconium et d'une solution solide de ceux-ci ; et
(b2) est formée immédiatement sur la couche du composé de titane ; et

(c) une couche d'un composé qui :

(c1) est formée d'une matière choisie dans le groupe constitué d'un carbure, d'un nitrure, d'un carbonitrure, d'un oxycarbure, d'un oxynitrure et d'un oxycarbonitrure (à l'exception de l'oxycarbonitrure ayant les mêmes rapports atomiques que ceux de la couche du premier composé) des métaux appartenant aux groupes IVa, Va et VIa du tableau périodique ; et

(c2) est formée dans la position située la plus à l'extérieur du revêtement.